**Europäisches Patentamt**

**European Patent Office**

**Office européen des brevets**

(19)

(11) Numéro de publication: **0 200 639**

**A1**

(12)

# DEMANDE DE BREVET EUROPEEN

(21) Numéro de dépôt: **86400874.3**

(22) Date de dépôt: **22.04.86**

(51) Int. Cl.⁴: **H 03 K 17/62**
**H 03 K 17/693**

(30) Priorité: **25.04.85 FR 8506337**

(43) Date de publication de la demande:
**05.11.86 Bulletin 86/45**

(84) Etats contractants désignés:
**AT BE CH DE GB IT LI LU NL SE**

(71) Demandeur: **TONNA ELECTRONIQUE**
**36, Avenue Hoche, Z.I.S.-E.**
**F-51060 Reims Cédex(FR)**

(72) Inventeur: **Jarret, Bertrand**
**15, Rue des Roses**
**95520 Osny(FR)**

(74) Mandataire: **Martin, Jean-Jacques et al,**
**Cabinet REGIMBEAU 26, Avenue Kléber**
**F-75116 Paris(FR)**

(54) **Dispositif électronique de commutation multivoie.**

(57) La présente invention concerne un dispositif électronique de commutation multivoie formant sélecteur entre une pluralité de voies de commutation (10, 20, 30) recevant en entrée des signaux respectivement associés ($E_1$, $E_2$, $E_3$) et dont les sorties sont connectées en commun. Selon l'invention, chaque voie de commutation comprend deux transistors ($T_{11}$, $T_{12}$ ; $T_{21}$, $T_{22}$; $T_{31}$, $T_{32}$) dont les trajets de conduction principale sont connectés en série, un transistor amont ($T_{11}$, $T_{21}$, $T_{31}$) de chaque voie recevant sur sa borne d'entrée le signal d'entrée respectivement associé et un transistor aval de chaque voie ($T_{12}$, $T_{22}$, $T_{32}$) recevant sur son entrée de commande un signal de commande de commutation en créneau basculant entre deux niveaux qui imposent respectivement le blocage et la conduction du transistor aval.

FIG-4

EP 0 200 639 A1

# DISPOSITIF ELECTRONIQUE DE COMMUTATION MULTIVOIE.

La présente invention concerne le domaine de la commutation électronique.

La présente invention concerne plus précisément un dispositif électronique de commutation multivoie formant sélecteur entre une pluralité de voies de commutation recevant en entrée des signaux respectivement associés et dont les sorties sont connectées en commun.

De nombreux dispositifs de commutation électronique ont déjà été proposés.

Ces dispositifs cependant, d'une façon générale, ne donnent pas satisfaction.

Les dispositifs électroniques multivoie jusqu'ici proposés sont en effet complexes, coûteux, et présentent en outre très souvent des performances médiocres, en particulier en ce qui concerne la caractéristique essentielle de diaphonie correspondant au rapport entre le signal issu d'un canal passant et le signal issu d'un canal bloqué.

La présente invention vient améliorer la situation en proposant selon un premier aspect, un dispositif électronique de commutation multivoie qui comprend sur chaque voie, au moins deux transistors dont les trajets de conduction principale sont connectés en série, un transistor amont de chaque voie recevant sur sa borne d'entrée le signal d'entrée respectivement associé et un transistor aval de chaque voie recevant sur son entrée de commande un signal de commande de commutation en créneau, basculant entre deux niveaux qui imposent respectivement le blocage et la conduction du transistor aval, et chacune des voies possédant en outre,

2

entre le transistor aval associé et le point commun
aux différentes voies de commutation une résistance
de charge du transistor aval et un étage transistorisé
auxiliaire.

L'étage transistorisé auxiliaire est de
préférence un montage du type collecteur commun ou
drain commun.

Avantageusement, chaque voie de commutation comprend en outre une diode entre l'émetteur ou
la source de l'étage transistorisé auxiliaire et le
point commun aux différentes voies de commutation.

Le cas échéant, sur chaque voie de commutation, une résistance est de plus connectée entre l'émetteur
ou la source de l'étage transistorisé auxiliaire et la
diode.

Selon une variante, l'étage transistorisé
auxiliaire est un montage du type émetteur commun ou
source commune comportant une résistance de charge dans
un circuit émetteur ou source.

Selon une autre caractéristique avantageuse
de la présente invention, il est prévu un dispositif
électronique de commutation multivoie formant sélecteur
entre une pluralité de voies de commutation recevant en
entrée des signaux respectivement associés et dont les
sorties sont connectées en commun, qui comprend, sur chaque
voie, au moins deux transistors dont les trajets de conduction principale sont connectés en série, un transistor
amont de chaque voie recevant sur sa borne d'entrée le
signal d'entrée respectivement associé et un transistor
aval de chaque voie recevant sur son entrée de commande un
signal de commande de commutation en créneau, basculant
entre deux niveaux qui imposent respectivement le blocage
et la conduction du transistor aval, et dans lequel le
point de sortie commun des différentes voies de commutation attaque un étage de sortie transistorisé.

Plus précisément encore, selon une caractéristique avantageuse de l'invention, l'étage de sortie transistorisé comporte une résistance de charge dans son circuit émetteur ou source, pour présenter une forte impédance d'entrée vis-à-vis des différentes voies de commutation.

Les transistors utilisés sur les différentes voies de commutation peuvent être soit des transistors bipolaires, soit des transistors à effet de champ.

D'autres caractéristiques et avantages de la présente invention apparaîtront à la lecture de la description détaillée qui va suivre et en regard des dessins annexés donnés à titre d'exemples non limitatifs, et sur lesquels :

- la figure 1 représente un premier mode de réalisation du dispositif de commutation multivoie conforme à la présente invention,

- les figures 2 et 3 représentent les schémas équivalents respectivement d'une voie passante et d'une voie bloquée du dispositif conforme au premier mode de réalisation,

- la figure 4 représente un second mode de réalisation du dispositif de commutation multivoie conforme à la présente invention,

- la figure 5 représente le schéma équivalent d'une voie bloquée du dispositif conforme au second mode de réalisation,

- la figure 6 représente un troisième mode de réalisation du dispositif de commutation multivoie conforme à la présente invention,

- la figure 7 représente le schéma équivalent d'une voie bloquée du dispositif conforme au troisième mode de réalisation

- la figure 8 représente un quatrième mode de réalisation du dispositif de commutation multivoie conforme à la présente invention,

- la figure 9 représente le schéma équivalent d'une voie bloquée du dispositif conforme au quatrième mode de réalisation.

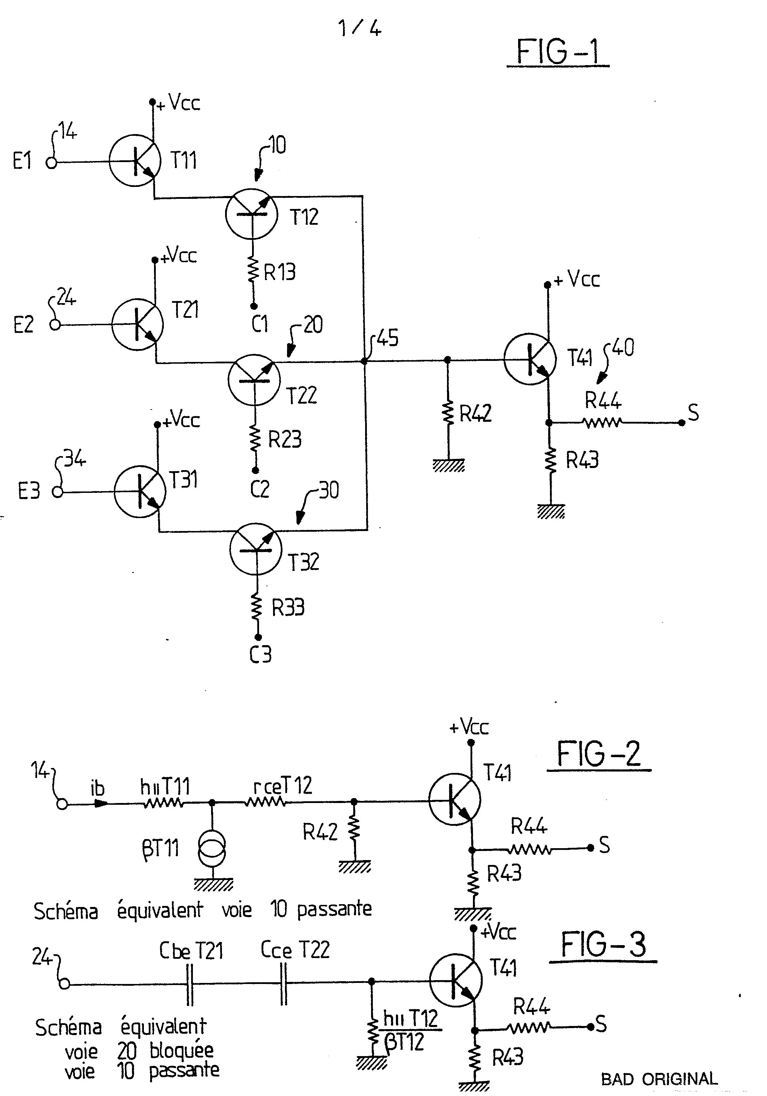

On va dans un premier temps décrire le premier mode de réalisation illustré sur la figure 1.

Sur la figure 1, on distingue un dispositif de commutation à trois voies référencées respectivement 10, 20, 30.

Le nombre de voies n'est cependant aucunement limitatif et l'homme de l'art comprendra aisément qu'un nombre de voies beaucoup plus important peut être retenu sans la moindre difficulté, et en particulier sans altérer les performances du circuit.

Les voies 10, 20, 30 reçoivent sur leur entrée 14, 24, 34 des signaux d'entrée respectivement associés $E_1$, $E_2$, $E_3$.

Les sorties des différentes voies 10, 20, 30 sont reliées à un point commun 45 qui attaque un étage de sortie 40.

Chaque voie 10, 20, 30 comprend deux transistors $T_{11}$, $T_{12}$; $T_{21}$, $T_{22}$; $T_{31}$, $T_{32}$, dont les trajets de conduction principale sont connectés en série.

La borne d'entrée du transistor amont de chaque voie ($T_{11}$, $T_{21}$, $T_{31}$) qui constitue l'entrée de celle-ci, reçoit le signal d'entrée $E_1$ à $E_3$ respectivement associé.

La borne de commande du transistor aval de chaque voie ($T_{12}$, $T_{22}$, $T_{32}$) reçoit un signal de commande de commutation $C_1$, $C_2$, $C_3$ en créneau, basculant entre deux niveaux qui imposent respectivement un état bloqué non passant et un état conducteur à l'état saturé du transistor aval $T_{12}$, $T_{22}$, $T_{32}$.

Selon le mode de réalisation représenté sur la figure annexée, les transistors $T_{11}$, $T_{12}$, $T_{21}$, $T_{22}$, $T_{31}$ et $T_{32}$ sont des transistors bipolaires NPN.

Plus précisément, les collecteurs des transistors amont $T_{11}$, $T_{21}$ et $T_{31}$ sont reliés à une borne d'alimentation positive + Vcc.

Les bases des transistors amont $T_{11}$, $T_{21}$, $T_{31}$ sont reliées aux entrées 14, 24 et 34 des différentes voies de commutation et reçoivent les signaux d'entrée $E_1$, $E_2$ et $E_3$ respectivement.

Les émetteurs des transistors amont $T_{11}$, $T_{21}$ et $T_{31}$ sont reliés aux collecteurs des transistors aval $T_{12}$, $T_{22}$ et $T_{32}$, respectivement.

Les bases de ces transistors aval $T_{12}$, $T_{22}$ et $T_{32}$ sont attaquées, par l'intermédiaire de résistances limitatrices de courant $R_{13}$, $R_{23}$ et $R_{33}$, par les signaux de commande de commutation $C_1$, $C_2$ et $C_3$ précités.

Enfin, les émetteurs de transistors aval $T_{12}$, $T_{22}$, $T_{32}$ qui constituent la sortie de chacune des voies de commutation 10, 20 et 30 sont reliés en commun au point 45 précité.

Bien entendu, les transistors bipolaires $T_{11}$, $T_{12}$, $T_{21}$, $T_{22}$, $T_{31}$ et $T_{32}$ pourront être remplacés par des transistors à effet de champ.

Dans un tel cas, les signaux d'entrée $E_1$, $E_2$ et $E_3$ seront appliqués sur les grilles des transistors amont remplaçant les transistors $T_{11}$, $T_{21}$ et $T_{31}$, tandis que les signaux de commande de commutation $C_1$, $C_2$ et $C_3$ seront appliqués sur les grilles des transistors aval remplaçant les transistors $T_{12}$, $T_{22}$ et $T_{32}$.

6

L'étage de sortie 40 attaqué par le point 45 commun aux différentes voies de commutation 10, 20 et 30 est formé d'un étage transistorisé collecteur commun selon le mode de réalisation représenté sur la figure annexée.

Plus précisément, cet étage 40 comprend un transistor $T_{41}$ NPN dont le collecteur est relié à une borne d'alimentation positive +Vcc et la base est reliée au point 45 précité.

Une résistance de charge $R_{42}$ est en outre connectée entre le point 45 et la masse du montage.

L'émetteur du transistor $T_{41}$ est également relié à la masse du montage par l'intermédiaire d'une résistance de charge $R_{43}$.

Enfin, la sortie S du dispositif de commutation est reliée à l'émetteur du transistor $T_{41}$ par l'intermédiaire d'une résistance $R_{44}$.

Selon le mode de réalisation illustré sur la figure annexée, les signaux de commande de commutation $C_1$, $C_2$ et $C_3$ appliqués sur la base des transistors aval $T_{12}$, $T_{22}$ et $T_{32}$ basculent entre deux niveaux correspondants respectivement à la tension de masse du montage et à la tension d'alimentation positive +Vcc.

De façon classique en soi, lorsque le niveau du signal de commande de commutation correspond au niveau de la masse du montage, le transistor correspondant $T_{12}$, $T_{22}$ ou $T_{32}$ est bloqué à l'état non passant et interrompt la transmission du signal d'entrée $E_1$, $E_2$ ou $E_3$ vers la sortie S du dispositif de commutation.

Inversement, lorsque le niveau du signal de commande de commutation $C_1$, $C_2$ ou $C_3$ appliqué sur la borne de commande de l'un des transistors $T_{12}$, $T_{22}$ ou $T_{32}$ correspond au niveau de la tension d'alimentation positive +Vcc, le transistor correspondant est porté à l'état conducteur et le signal d'entrée $E_1$, $E_2$ ou $E_3$ de la voie passante se retrouve au niveau de la sortie S de l'étage 40.

Comme cela apparaît à l'examen de la figure 2, pour une voie passante, le générateur du signal d'entrée $E_1$, $E_2$ ou $E_3$ voit une impédance d'entrée :

(1)     $Ze \# h_{11}T_{11} + \beta T_{11} \cdot (rce T_{12} + R_{42})$

relation dans laquelle :

. $h_{11}T_{11}$ et $\beta T_{11}$ représentent les paramètres classiques du transistor amont ($T_{11}$ par exemple) d'une voie passante et

. $rce T_{12}$ représente la résistance collecteur-émetteur du transistor aval passant.

La résistance collecteur-émetteur du transistor aval passant est négligeable devant $R_{42}$, soit

(2)     $Ze \# h_{11}T_{11} + 3T_{11} \cdot R_{42}$.

De même, l'impédance $h_{11}T_{11}/3T_{11}$ du transistor amont $T_{11}$, $T_{21}$ ou $T_{31}$ peut être négligée par rapport à la charge $R_{42}$.

Dans ces conditions, les pertes dans une voie passante 10, 20 ou 30 sont faibles et quasiment constantes.

On remarquera par ailleurs que les dispersions des transistors n'ont aucune incidence sur le niveau du signal en sortie.

Par contre, comme cela apparaît à l'examen de la figure 3, pour une voie bloquée (signal de commande de commutation au niveau bas) le signal parasite passant par les capacités base-émetteur $Cbe\ T_{21}$ du transistor amont ($T_{21}$ par exemple) et collecteur-émetteur $Cce\ T_{22}$ du transistor aval ($T_{22}$ par exemple) de la voie bloquée, est shunté en entrée de l'étage 40 par l'impédance $h_{11}T_{12}/\beta T_{12}$, de valeur très faible, du transistor aval ($T_{12}$ par exemple) de la voie passante. De ce fait, le dispositif de commutation conforme à la présente invention présente d'excellentes performances en diaphonie.

L'impédance d'entrée d'une voie bloquée, 20 par exemple, est égale à :

$$(3) \quad h_{11}T_{21} + \beta T_{21} \left( rceT_{22} + \frac{h_{11}T_{12}}{\beta T_{12}} \right)$$

on considérant par exemple que la voie 10 est passante, $h_{11}T_{12}$ et $\beta T_{12}$ représentant les paramètres classiques du transistor aval (12) d'une voie passante, $h_{11}T_{21}$ et $\beta T_{21}$ représentant les paramètres classiques du transistor amont d'une voie bloquée et $rceT_{22}$ représentant la résistance collecteur-émetteur du transistor aval d'une voie bloquée. On remarquera à l'examen de cette relation (3) que l'impédance d'entrée des différentes voies est très élevée en raison de la présence du terme $h_{11}$.

La fonction de transfert d'une voie passante est définie par la relation :

$$(4) \quad U_E T_{41} \neq E_n$$

dans laquelle

$U_E T_{41}$ représente la tension sur l'émetteur du transistor de sortie $T_{41}$, et

$E_n$ représente le signal ($E_1$, $E_2$ ou $E_3$) sur l'entrée (14, 24 ou 34) d'une voie passante (10, 20 ou 30).

La fonction de transfert d'une voie bloquée est définie par la relation :

$$(5) \quad U_E T_{41} \neq E_n \cdot \frac{j \ h_{11}T_{12} \cdot C_1 w}{\beta T_{12} + j \ h_{11}T_{12} \cdot C_1 w}$$

dans laquelle

$\cdot$ $1/C_1$ représente la somme des impédances base-émetteur $1/CbeT_{21}$ du transistor amont et collecteur-émetteur $1/Cce \ T_{22}$ du transistor aval d'une voie bloquée,

$\cdot$ $\beta T_{12}$ et $h_{11}T_{12}$ représente les paramètres classiques du transistor aval d'une voie passante.

On en déduit que la diaphonie correspondant au rapport entre le signal issu d'un canal passant et le signal issu d'un canal bloqué est égale à :

$$(6) \quad D \# \frac{E_n}{E_n \dfrac{jh_{11}T_{12} \cdot C_1 w}{\beta T_{12} + j \cdot h_{11}T_{12} \cdot C_1 w}} \quad \text{soit}$$

$$(7) \quad D \# \frac{\sqrt{\beta^2 T_{12} + (h_{11}T_{12} \cdot C_1 w)^2}}{h_{11}T_{12} \cdot C_1 w}$$

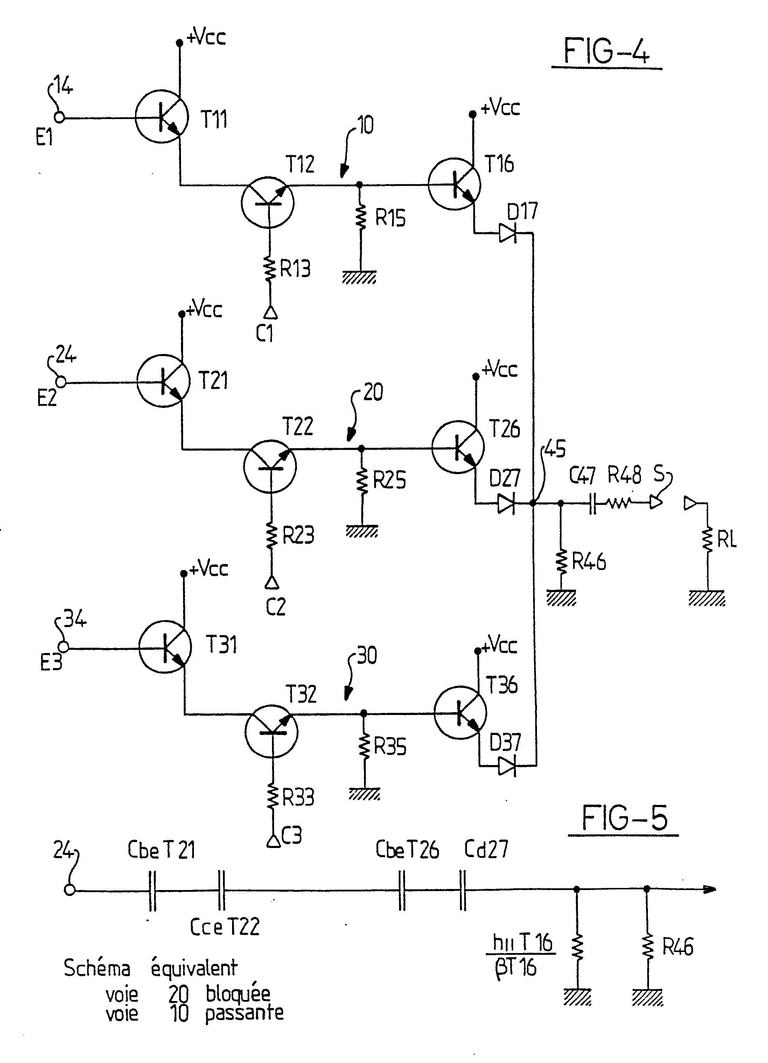

On va maintenant décrire le second mode de réalisation représenté sur la figure 4.

On retrouve sur cette figure 4 les transistors $T_{11}$, $T_{21}$, $T_{31}$ recevant sur leur borne d'entrée les signaux $E_1$, $E_2$ et $E_3$, les transistors $T_{12}$, $T_{22}$ et $T_{32}$ recevant par l'intermédiaire des résistances $R_{13}$, $R_{23}$ et $R_{33}$ respectivement les signaux de commutation $C_1$, $C_2$ et $C_3$.

Néanmoins, le second mode de réalisation illustré sur la figure 4 ne comporte pas un étage transistorisé de sortie commun aux différentes voies. Par ailleurs, les émetteurs ou sources des transistors aval $T_{12}$, $T_{22}$ et $T_{32}$ ne sont pas reliés directement au point commun 45.

Les émetteurs ou sources des transistors aval $T_{12}$, $T_{22}$ et $T_{32}$ sont chargés par des résistances $R_{15}$, $R_{25}$ et $R_{35}$ respectivement.

De plus, les émetteurs ou sources des transistors aval $T_{12}$, $T_{22}$ et $T_{32}$ attaquent respectivement la base ou grille d'un transistor auxiliaire respectif $T_{16}$, $T_{26}$ et $T_{36}$.

Ce dernier est monté en collecteur ou drain commun.

Selon la représentation de la figure 4, les transis-

tors $T_{16}$, $T_{26}$ et $T_{36}$ sont du type bipolaire NPN, les collecteurs de ces transistors sont donc reliés à une borne d'alimentation positive +Vcc.

Les émetteurs ou sources des transistors auxiliaires $T_{16}$, $T_{26}$ et $T_{36}$ sont reliés en commun en 45.

Ce point 45 commun aux différentes voies de commutation est chargé par une résistance $R_{46}$ connectée à la masse.

Le point 45 commun aux différentes voies de commutation est de plus relié à la sortie S du dispositif par l'intermédiaire d'une branche comprenant en série une capacité $C_{47}$ et une résistance $R_{48}$.

L'impédance de charge de la sortie S du dispositif de commutation est référencée RL sur la figure 4.

La résistance $R_{48}$ est choisie telle que

$$(8) \qquad \frac{h_{11}T_{16}}{\beta T_{16}} + R_{48} \simeq RL$$

relation dans laquelle

$h_{11} T_{16}$ et $\beta T_{16}$ représentent les paramètres classiques d'un transistor auxiliaire ($T_{16}$ par exemple) à l'état passant, et

$$(9) \qquad R_{46} >> (R_{48} + RL);$$

Pour une voie passante, le générateur du signal d'entrée $E_1, E_2$ ou $E_3$ voit une impédance d'entrée :

$$(10) \qquad Ze \simeq h_{11}T_{11} + \beta T_{11} \cdot (rce\ T_{12} + R_{n5})$$

relation dans laquelle

. $h_{11}T_{11}$ et $\beta T_{11}$ représentent les paramètres classiques du transistor amont ($T_{11}$ par exemple) d'une voie passante et

. rce $T_{12}$ représente la résistance collecteur-émetteur du transistor aval passant, et

. $R_{n5}$ représente la résistance $R_{15}$, $R_{25}$ ou $R_{35}$ de la voie passante.

$R_{n5}$ étant choisi tel que

$R_{n5} \gg h_{11} T_{11}$ et $R_{n5} \gg Rce\ T_{12}$

(11)     $Ze \# \beta T_{11} \cdot R_{n5}.$

L'impédance d'entrée d'une voie bloquée, 10 par exemple, est égale à :

(12)     $Ze \# h_{11}T_{21} + \beta T_{21}(rce\ T_{22} + R_{p5})$

dans laquelle

• $h_{11}T_{21}$ et $\beta T_{21}$ représentent les paramètres classiques du transistor amont ($T_{21}$ par exemple) d'une voie bloquée,

• rce $T_{22}$ représente la résistance collecteur-émetteur du transistor aval ($T_{22}$ par exemple) de la voie bloquée et

• $R_{p5}$ représente la résistance $R_{15}$, $R_{25}$ ou $R_{35}$ de la voie bloquée.

On remarquera à l'examen de la relation (12) que l'impédance d'entrée des différentes voies est très élevée en raison de la présence du terme $h_{11}$.

Si l'on considère comme nulle la résistance d'une diode ($D_{17}$, $D_{27}$. $D_{37}$) dans le sens passant la fonction de transfert d'une voie passante est définie par la relation :

(13)     $U_{R46} \# E_n$     dans laquelle

• $U_{R46}$ représente le signal sur la résistance $R_{46}$ et

• En représente le signal ($E_1$, $E_2$ ou $E_3$) sur l'entrée (14, 24 ou 34) d'une voie passante (10, 20 ou 30).

La fonction de transfert d'une voie bloquée (20 par exemple) est définie par la relation :

(14)     $U_{R46} \# E_n \dfrac{j \cdot h_{11}T_{16} \cdot C_2 w}{j \cdot h_{11}T_{16} \cdot C_2 w + \beta T_{16}}$

dans laquelle

$1/C_2$ représente la somme des impédances base-émetteur $1/Cbe\ T_{21}$ du transistor amont, collecteur-émetteur $1/Cce\ T_{22}$ du transistor aval, base-émetteur $1/Cbe\ T_{26}$ du transistor auxiliaire et de la diode $1/Cd_{27}$ d'une voie bloquée, . $\beta T_{16}$ et $h_{11}\ T_{16}$ représentent les paramètres classiques du transistor auxiliaire ($T_{16}$ par exemple) d'une voie passante, soit

$$(15) \qquad U_{R46} \neq En\ \frac{jh_{11}\ T_{16}\ \cdot\ C_2 w}{\beta T_{16}}$$

La diaphonie correspondant au rapport entre le signal issu d'un canal passant et le signal issu d'un canal bloqué est donc égale à :

$$(16) \qquad D \neq \frac{E_n}{E_n\ \dfrac{jh_{11}T_{16}\ \cdot\ C_2 w}{\beta T_{16}}} = \frac{\beta T_{16}}{jh_{11}T_{16}\ \cdot\ C_2 w}$$

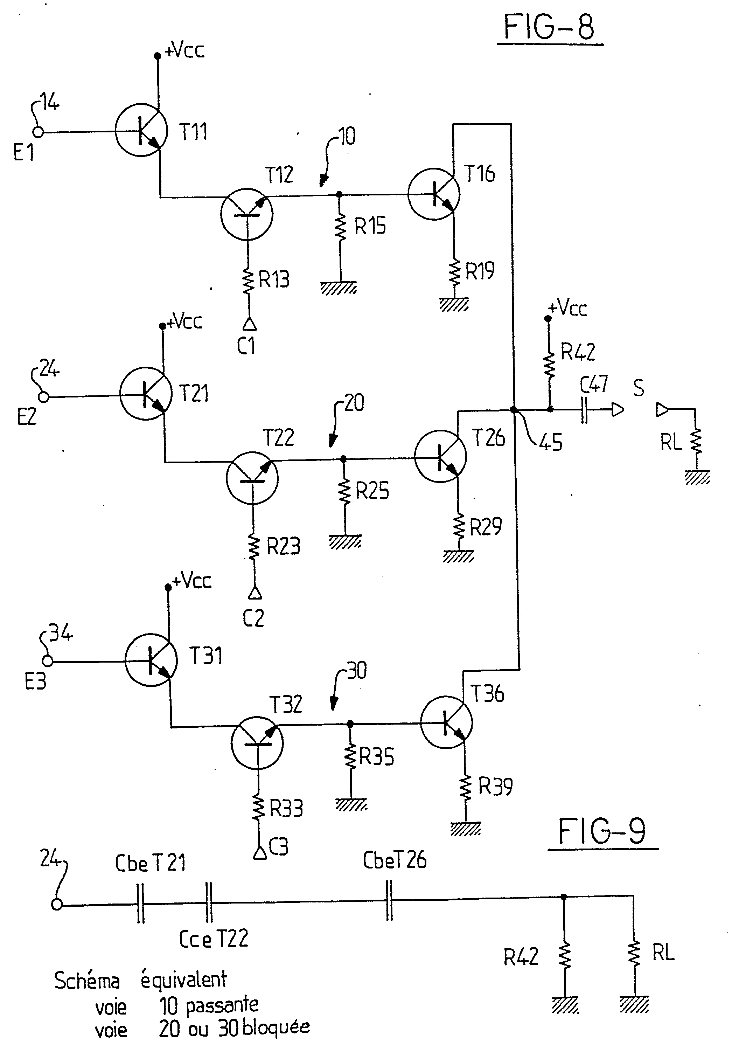

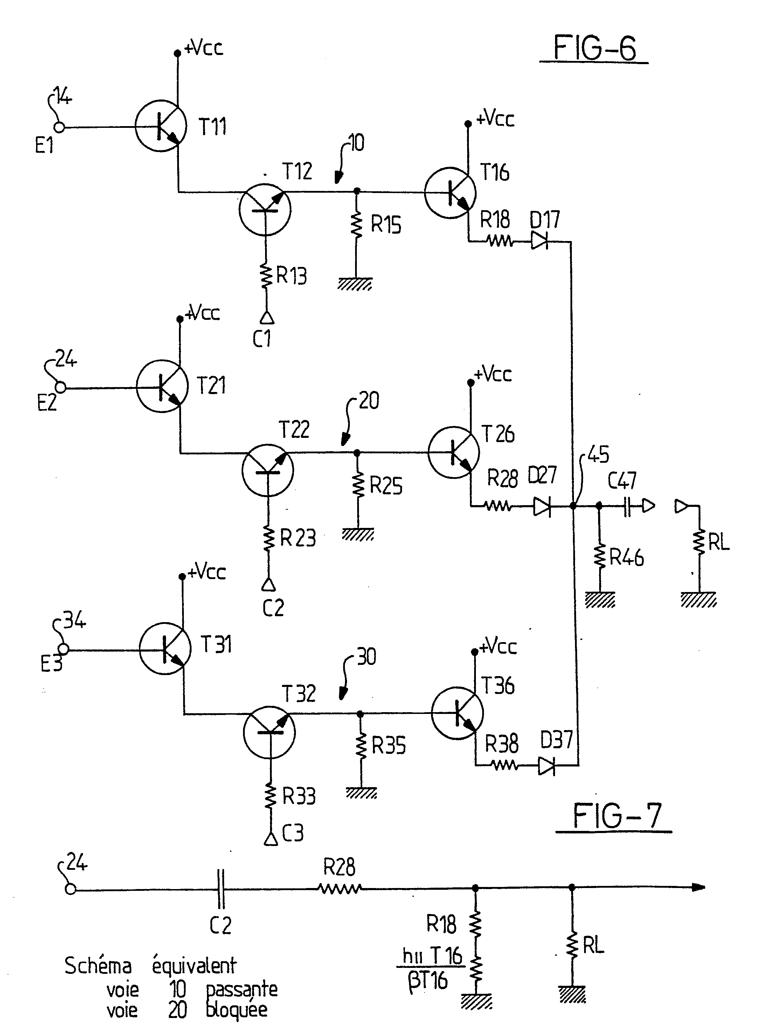

On va maintenant décrire le troisième mode de réalisation représenté sur la figure 6.

Ce troisième mode de réalisation est très proche du second représenté sur la figure 4.

Néanmoins, ce troisième mode de réalisation diffère du second par le fait que la résistance $R_{48}$ est supprimée et une résistance de charge $R_{18}$, $R_{28}$ et $R_{38}$ respectivement est introduite dans le circuit émetteur ou source des transistors auxiliaires $T_{16}$, $T_{26}$ et $T_{36}$ entre l'émetteur ou la source de ceux-ci et la diode associée $D_{17}$, $D_{27}$ et $D_{37}$.

On choisit $R_{n8}$ (ie, $R_{18}$, $R_{28}$ et $R_{38}$) telle que $(h_{11}T_{n6}\ /\beta T_{n6}) + R_{n8} \neq RL$, relation dans laquelle $h_{11}T_{n6}$ et $\beta T_{n6}$ représentent les paramètres classiques des transistors auxiliaires $T_{16}$, $T_{26}$ ou $T_{36}$.

De plus, on choisit $R_{46} \gg RL$.

L'impédance d'entrée vue par le générateur de signal d'entrée, pour une voie passante est identique à celui du second mode de réalisation soit :

$$(10) \qquad Ze \; \# \; h_{11}T_{11} + \beta T_{11} \cdot (rce \; T_{12} + R_{n5}) \qquad et$$

$$(11) \qquad Ze \; \# \; \beta T_{11} \cdot R_{n5}.$$

De même, l'impédance d'entrée d'une voie bloquée est égale à :

$$(12) \qquad Ze \; \# \; h_{11}T_{21} + \beta T_{21}(rce \; T_{22} + R_{p5})$$

et est donc très élevée en basse fréquence.

Comme on l'a indiqué précédemment, $(h_{11}T_{n6}/\beta T_{n6}) + R_{48} \; \# \; RL$ et $R_{46} >> RL$, la fonction de transfert d'une voie passante est donc définie par la relation :

$$(17) \quad U_{RL} \; \# \; E_n/2.$$

De plus, on choisit $R_{n8} >> h_{11}T_{n6}/\beta T_{n6}$ soit $R_{n8} \; \# \; RL$ puisque $(h_{11}T_{n6}/\beta T_{n6}) + R_{n8} \; \# \; RL.$

De ce fait, la fonction de transfert d'une voie bloquée (20 par exemple) est définie par la relation:

$$(18) \quad U_{RL} \; \# \; E_n \frac{RL/2}{RL/2 + RL + \dfrac{1}{jC_2 \cdot w}} \qquad soit$$

$$(19) \quad U_{RL} \; \# \; E_n \cdot \frac{RL}{2} \cdot C_2 w \qquad relations \; dans \; lesquelles :$$

. $U_{RL}$ représente le signal sur la résistance RL, et

. $1/C2$ représente la somme des impédances base-émetteur $1/Cbe \; T_{21}$ du transistor amont, collecteur-émetteur $1/Cce \; T_{22}$ du transistor aval, base-émetteur $1/Cbe \; T_{26}$ du transistor auxiliaire et de la diode $1/Cd27$ d'une voie bloquée.

La diaphonie correspondant au rapport entre le signal issu d'un canal passant et le signal issu d'un canal bloqué est donc égale à :

$$(20) \quad D = \frac{E_n/2}{E_n/2 \ . \ RL \ . \ C_2. \ \varpi} = \frac{1}{RL.C_2 \ . \ \varpi}$$

Le cas échéant, les diodes $D_{17}$, $D_{27}$ et $D_{37}$ peuvent être supprimées. Ces diodes permettent essentiellement de réduire la capacité équivalente $C_2$, donc d'améliorer les performances en diaphonie.

On va maintenant décrire le quatrième mode de réalisation représenté sur la figure 8.

On retrouve sur cette figure 8, les transistors $T_{11}$, $T_{21}$, $T_{31}$ recevant sur leur borne d'entrée les signaux $E_1$, $E_2$ et $E_3$, les transistors $T_{12}$, $T_{22}$ et $T_{32}$ recevant par l'intermédiaire des résistances $R_{13}$, $R_{23}$ et $R_{33}$ respectivement les signaux de commutation $C_1$, $C_2$ et $C_3$.

Néanmoins, là encore, le quatrième mode de réalisation illustré sur la figure 8 ne comporte pas un étage transistorisé de sortie commun aux différentes voies. Par ailleurs, là encore, les émetteurs ou sources des transistors aval $T_{12}$, $T_{22}$ et $T_{32}$ ne sont pas reliés directement au point commun 45.

Les émetteurs ou sources des transistors aval $T_{12}$, $T_{22}$ et $T_{32}$ sont chargés par des résistances $R_{15}$, $R_{25}$ et $R_{35}$ respectivement.

De plus, les émetteurs ou sources des transistors aval $T_{12}$, $T_{22}$ et $T_{32}$ attaquent respectivement la base ou grille d'un transistor auxiliaire respectif $T_{16}$, $T_{26}$ ou $T_{36}$.

Les émetteurs ou sources de ces transistors $T_{16}$, $T_{26}$ ou $T_{36}$ sont relié(e)s à la masse par l'intermédiaire de résistances $R_{19}$, $R_{29}$ et $R_{39}$ respectivement.

Les collecteurs ou drains des transistors auxiliaires $T_{16}$, $T_{26}$ et $T_{36}$ sont reliés en commun au point 45.

Ce point 45 commun aux différentes voies de commutation est chargé par une résistance $R_{42}$ connectée à une borne d'alimentation positive + Vcc.

Le point 45 commun aux différentes voies est de plus relié à la sortie S du dispositif par l'intermédiaire d'une capacité C47.

L'impédance de charge de la sortie S du dispositif de commutation est référencée RL sur la figure 9.

La résistance $R_{42}$ est choisie telle que $R_{42} \# R_L$.

L'impédance d'entrée d'une voie passante est identique à celle définie pour les seconde et troisième variantes, soit :

(11)  $Ze \# \beta T_{11} \cdot R_{n5}$

De même, l'impédance d'entrée d'une voie bloquée est identique à celle définie pour les seconde et troisième variantes, soit :

(12) $Ze \# h_{11}T_{21} + \beta T_{21} (rce\ T_{22} + R_{p5})$
et est donc très élevée en basse fréquence.

Le courant de collecteur $Ic\ T_{n6}$ du transistor auxiliaire passant $T_{n6}$ étant de l'ordre de

(21) $Ic\ T_{n6} \# E_n/R_{n9}$, relation dans laquelle $R_{n9}$ désigne l'une des résistances de charge du circuit émetteur ou source du transistor auxiliaire $T_{n6}$ passant, la tension aux bornes de la résistance de charge RL est alors :

(22) $U_{RL} \# \dfrac{R_{42} \cdot RL}{R_{42} + RL} \cdot \dfrac{E_n}{R_{n9}}$ soit

avec $RL \# R_{42}$ :

$$(23) \qquad U_{RL} \; \# \; E_n \; \frac{R\,L}{2.R_{n_9}}$$

Par contre, la fonction de transfert d'une voie bloquée est définie par la relation :

$$(24) \qquad U_{RL} \; \# \; E_n \; \frac{RL}{2} \; . \; C_3 w,$$

relation dans laquelle :

. $1/C_3$ représente la somme des impédances base-émetteur $1/CbeT_{21}$ du transistor amont, collecteur-émetteur $1/Cce$ $T_{22}$ du transistor aval, base-collecteur $1/CbcT_{26}$ du transistor auxiliaire d'une voie bloquée.

La diaphonie correspondant au rapport entre le signal issu d'un canal passant et le signal issu d'un canal bloqué est donc égale à :

$$(25) \; D \; \# \; \frac{E_n \; \dfrac{RL}{2R_{n9}}}{E_n \; \dfrac{RL}{2} \; C_3 \; w} \; = \; \frac{1}{R_{n9}C_3 w}$$

Par rapport aux dispositifs de commutation multivoie jusqu'ici proposés, le dispositif conforme à la présente invention présente de nombreux avantages parmi lesquels on citera une impédance d'entrée élevée, une faible distorsion, une bonne reproductibilité, et enfin une commutation possible de nombreux types de signaux tels que signaux vidéo, hautes fréquences, digitaux ou équivalents. On notera également que la consommation est faible et constante quel que soit le nombre de canaux du dispositif.

REVENDICATIONS

1. Dispositif électronique de commutation multivoie formant sélecteur entre une pluralité de voies de commutation (10, 20, 30) recevant en entrée des signaux respectivement associés et dont les sorties sont connectées en commun, caractérisé par le fait qu'il comprend, sur chaque voie au moins deux transistors ($T_{11}$, $T_{12}$ ; $T_{21}$, $T_{22}$ ; $T_{31}$, $T_{32}$) dont les trajets de conduction principale sont connectés en série, un transistor amont de chaque voie ($T_{11}$, $T_{21}$, $T_{31}$) recevant sur sa borne d'entrée le signal d'entrée respectivement associé ($E_1$, $E_2$ et $E_3$) et un transistor aval ($T_{12}$, $T_{22}$, $T_{32}$) de chaque voie recevant sur son entrée de commande un signal de commande de commutation ($C_1$, $C_2$, $C_3$) en créneau, basculant entre deux niveaux qui imposent respectivement le blocage et la conduction du transistor aval, et
par le fait que chacune des voies (10, 20, 30) possède en outre, entre le transistor aval associé ($T_{12}$, $T_{22}$, $T_{32}$) et le point (45) commun aux différentes voies de commutation (10, 20, 30) une résistance de charge ($R_{15}$, $R_{25}$, $R_{35}$) du transistor aval et un étage transistorisé auxiliaire ($T_{16}$, $T_{26}$, $T_{36}$).

2. Dispositif électronique de commutation multivoie selon la revendication 1, caractérisé par le fait que l'étage transistorisé auxiliaire ($T_{16}$, $T_{26}$, $T_{36}$) est un montage du type collecteur commun ou drain commun.

3. Dispositif électronique de commutation multivoie selon la revendication 2, caractérisé par le fait que chaque voie de commutation (10, 20, 30) comprend en outre une diode ($D_{17}$, $D_{27}$, $D_{37}$) entre l'émetteur ou la source de l'étage transistorisé auxiliaire ($T_{16}$, $T_{26}$, $T_{36}$) et le point (45) commun aux différentes voies de commutation (10, 20, 30).

4. Dispositif électronique de commutation multivoie selon la revendication 3, caractérisé par le fait que chaque voie de commutation (10, 20, 30) comprend en outre une résistance de charge ($R_{18}$, $R_{28}$, $R_{38}$) entre l'émetteur ou la source du transistor auxiliaire ($T_{16}$, $T_{26}$, $T_{36}$) et la diode associée ($D_{17}$, $D_{27}$, $D_{37}$).

5. Dispositif électronique de commutation multivoie selon la revendication 1, caractérisé par le fait que au niveau de l'étage transistorisé auxiliaire ($T_{16}$, $T_{26}$, $T_{36}$) l'émetteur ou la source des transistors est relié(e) à la masse par une résistance.

6. Dispositif électronique de commutation multivoie formant sélecteur entre une pluralité de voies de commutation (10, 20, 30) recevant en entrée des signaux respectivement associés et dont les sorties sont connectées en commun, caractérisé par le fait qu'il comprend, sur chaque voie au moins deux transistors ($T_{11}$, $T_{12}$ ; $T_{21}$, $T_{22}$ ; $T_{31}$, $T_{32}$) dont les trajets de conduction principale sont connectés en série, un transistor amont de chaque voie ($T_{11}$, $T_{21}$, $T_{31}$) recevant sur sa borne d'entrée le signal d'entrée respectivement associé ($E_1$, $E_2$ et $E_3$) et un transistor aval ($T_{12}$, $T_{22}$, $T_{32}$) de chaque voie recevant sur son entrée de commande un signal de commande de commutation ($C_1$, $C_2$, $C_3$) en créneau, basculant entre deux niveaux qui imposent respectivement le blocage et la conduction du transistor aval, et par le fait que le point de sortie commun (45) des différentes voies de commutation (10, 20, 30) attaque un étage de sortie transistorisé (40).

7. Dispositif électronique de commutation multivoie selon la revendication 6, caractérisé par le fait que l'étage de sortie transistorisé (40) comporte une résistance de charge (43) dans son circuit émetteur ou source, pour présenter une forte impédance d'entrée vis-à-vis des différentes voies de commutation.

8. Dispositif électronique de commutation multivoie selon l'une des revendications 1 à 7, caractérisé par le fait que les transistors $T_{11}$, $T_{12}$ ; $T_{21}$, $T_{22}$ ; $T_{31}$, $T_{32}$) de chaque voie de commutation (10, 20, 30) sont des transistors bipolaires.

9. Dispositif électronique de commutation multivoie selon l'une des revendications 1 à 7, caractérisé par le fait que les transistors ($T_{11}$, $T_{12}$ ; $T_{21}$, $T_{22}$ ; $T_{31}$, $T_{32}$) de chaque voie de commutation sont des transistors à effet de champ.

0200639

1/4

**FIG-1**

Schéma équivalent voie 10 passante

**FIG-2**

Schéma équivalent
voie 20 bloquée
voie 10 passante

**FIG-3**

BAD ORIGINAL

0200639

FIG-4

FIG-5

Schéma équivalent
voie 20 bloquée
voie 10 passante

FIG-8

FIG-9

Schéma équivalent
voie 10 passante
voie 20 ou 30 bloquée

0200639

3/4

FIG-6

FIG-7

Schéma équivalent
voie 10 passante
voie 20 bloquée

0200639

Office européen
des brevets

**RAPPORT DE RECHERCHE EUROPEENNE**

Numero de la demande

EP  86 40 0874

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PATENTS ABSTRACTS OF JAPAN, vol. 7, no. 140 (E-182)[1285], 18 juin 1983; & JP - A - 58 53 226 (TOKYO SHIBAURA DENKI K.K.) 29-03-1983 * Abrégé * | 6-8 | H 03 K   17/62 H 03 K   17/693 |
| Y | IDEM | 1-4,9 | |
| Y | FR-A-2 247 033   (IBM) * Page 5, ligne 35 - page 9, ligne 7; figure 2 * | 1,2 | |
| Y | FR-A-2 177 778   (VEB STUDIOTECHNIK BERLIN) * Page 4, ligne 7 - page 5, ligne 2; figures 2,3 * | 1-4 | DOMAINES TECHNIQUES RECHERCHES (Int. Cl.4) |
| Y | EP-A-0 046 197   (IBM) * Page 5 - page 6, ligne 20; figure 1 * | 9 | H 03 K |
| A | IBM TECHNICAL DISCLOSURE BULLETIN, vol. 27, no. 4A, septembre 1984, pages 1981,1982, New York, US; D. OMET; " Demultiplexer circuit for testing embedded arrays" * Page 1982, dernier alinéa; figure 2 * | 5 | |

Le présent rapport de recherche a été établi pour toutes les revendications

| Lieu de la recherche | Date d'achèvement de la recherche | Examinateur |
|---|---|---|
| LA HAYE | 29-07-1986 | CANTARELLI R.J.H. |